# EUROPEAN PATENT APPLICATION

(11) **EP 4 318 575 A1**
(43) Date of publication of application: **07.02.2024**
(21) Application number: 22807126.2
(22) Date of filing: 07.03.2022
(51) Int. Cl.: H01L 23/473, H05K 7/20

(54) **COOLING COMPONENT**

(30) Priority: 14.05.2021 JP 2021082123
(71) Applicant: NEC Platforms, Ltd., Kanagawa 213-8511 (JP)
(72) Inventor: OCHIAI, Syoji, Kawasaki-shi, Kanagawa 213-8511 (JP)
(74) Representative: Vossius & Partner Patentanwälte Rechtsanwälte mbB
(86) International application number: PCT/JP2022/009616
(87) International publication number: WO 2022/239419

(57) **Abstract**

In order to make it possible to provide a cooling component which can efficiently cool a portion, of a heating body, heated to a higher temperature without increasing the area of a heat sink, this cooling component includes a first portion corresponding to a first region of the heating body, and a second portion corresponding to a second region of the heating body heated to a higher temperature than the first region, wherein the second portion is provided with a plurality of protruding sections, each of the protruding sections of the second portion forms a flow passage through which a refrigerant flows, and the first portion is not provided with a flow passage.

## Description

### Technical Field

The present invention relates to a cooling component.

### Background Art

There is a cooling component that cools a heating body that generates heat. PTL 1 describes providing a plurality of protruding sections as fins at equal intervals from one end to the other end facing each other inside a cold plate, and allowing a liquid refrigerant to flow between the protruding sections to cool a large-scale integration (LSI) that generates heat.

In a heat sink described in PTL 2, an area of another heat dissipation region that dissipates heat of a heat generating component having a low temperature guarantee value is larger than an area of one heat dissipation region that dissipates heat of a heat generating component having a high temperature guarantee value. Further, in PTL 2, the number of protruding sections which are fins is increased in the other heat dissipation region having a larger area than the fin in one heat dissipation region, and heat dissipation capability of the heat sink is enhanced.

### Citation List

### Patent Literature

PTL 1: JP 2010-080455 A
PTL 2: WO 2011/096218 A1

### Summary of Invention

### Technical Problem

However, since the cold plate described in PTL 1 is provided with protruding sections at equal intervals inside the cold plate, an entire LSI is uniformly cooled regardless of a difference in heat generation amount for each part of the LSI. Generally, in the LSI, a portion having a different heat generation temperature is generated according to a processing load of an internal electronic circuit, and a portion having a high processing load of the LSI has a higher temperature than the other portions. However, when the entire LSI is uniformly cooled like the cold plate described in PTL 1, it is not possible to improve cooling performance for heating bodies having portions at different heating temperatures. This is because a portion of the LSI that generates heat at a higher temperature cannot be efficiently cooled.

In the configuration of the heat sink described in PTL 2, in order to enhance the heat dissipation capability of the heat dissipation region, it is necessary to expand the area of the heat dissipation region of the heat sink, and the heat sink becomes large.

An object of the present invention is to provide a cooling component capable of efficiently cooling a portion of a heating body that generates heat at a higher temperature without increasing the area of the heat sink.

### Solution to Problem

In one aspect of the present invention, a cooling component includes a first portion related to a first region of a heating body and a second portion related to a second region of the heating body, the second portion having a higher temperature than the first region. The second portion includes a plurality of protruding sections, each of the plurality of protruding sections of the second portion forms a flow passage through which a refrigerant passes, and the first portion is not provided with the flow passage.

In one aspect of the present invention, a cooling component includes a first portion related to a first region of a heating body and a second portion related to a second region of the heating body, the second portion having a higher temperature than the first region. The second portion includes a plurality of protruding sections, the first portion includes a plurality of protruding sections thicker than the plurality of protruding sections of the second portion, and each of the plurality of protruding sections of the second portion and the plurality of protruding sections of the first portion forms a flow passage through which a refrigerant passes.

### Advantageous Effects of Invention

With the cooling component of the present invention, it is possible to efficiently cool a portion of the heating body that generates heat at a higher temperature without increasing the area of the heat sink.

### Brief Description of Drawings

[Fig. 1] Fig. 1 is a transparent perspective view illustrating a configuration example of a cooling component according to a first example embodiment of the present invention.
[Fig. 2] Fig. 2 is a cross-sectional view illustrating the configuration example of the cooling component according to the first example embodiment of the present invention.
[Fig. 3] Fig. 3 is a transparent perspective view illustrating the configuration example of the cooling component and a heating body according to the first example embodiment of the present invention.
[Fig. 4] Fig. 4 is a cross-sectional view illustrating the configuration example of the cooling component and the heating body according to the first example embodiment of the present invention.
[Fig. 5] Fig. 5 is a diagram illustrating an example of simulation results of the cooling component of the first example embodiment of the present invention and a cooling component of a comparative example.
[Fig. 6] Fig. 6 is a transparent perspective view illustrating a configuration example of a cooling component and a heating body according to a second example embodiment of the present invention.
[Fig. 7] Fig. 7 is a cross-sectional view illustrating the configuration example of the cooling component and the heating body according to the second example embodiment of the present invention.
[Fig. 8] Fig. 8 is a transparent perspective view illustrating a configuration example of a cooling component according to a third example embodiment of the present invention.
[Fig. 9] Fig. 9 is a cross-sectional view illustrating the configuration example of the cooling component according to the third example embodiment of the present invention.
[Fig. 10] Fig. 10 is a transparent perspective view illustrating the configuration example of the cooling component and the heating body according to the third example embodiment of the present invention.
[Fig. 11] Fig. 11 is a cross-sectional view illustrating the configuration example of the cooling component and the heating body according to the third example embodiment of the present invention.

### [First example embodiment]

The first example embodiment of the present invention will be described.

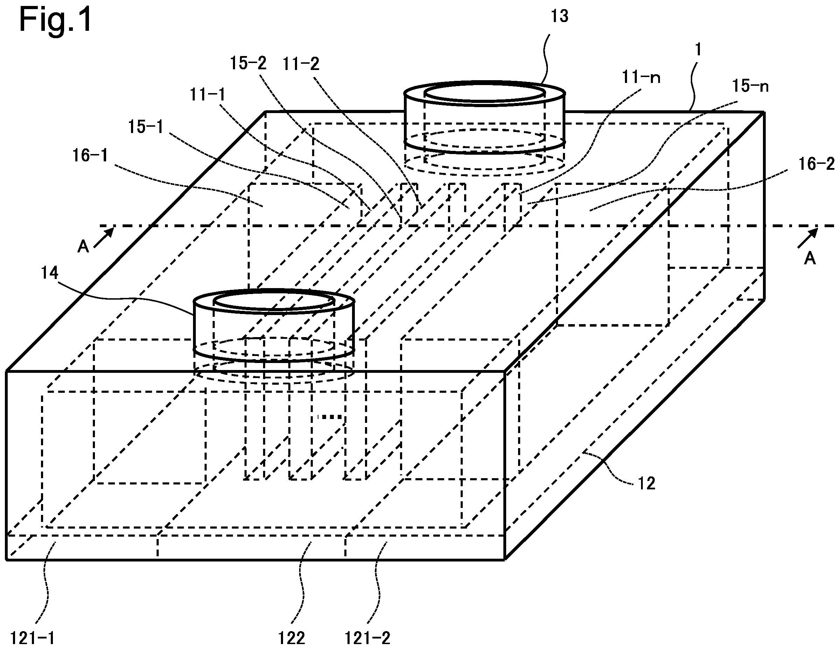

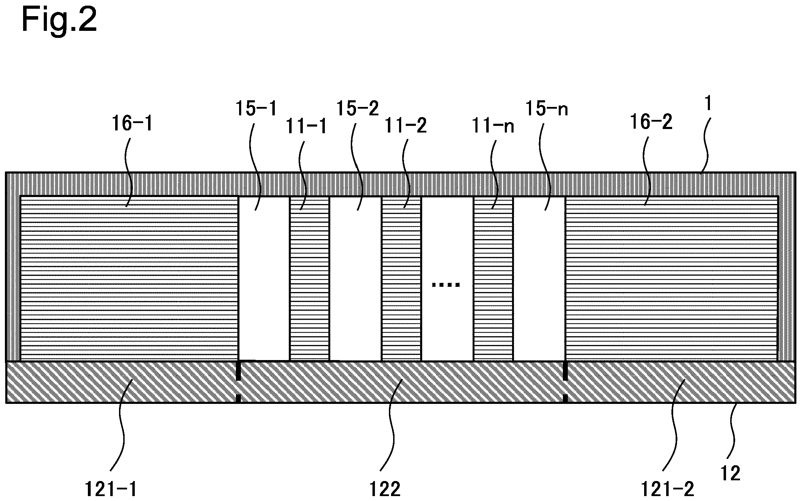

Fig. 1 is the transparent perspective view illustrating the configuration example of a cooling component 1 of the present example embodiment. Fig. 2 is the cross-sectional view illustrating the configuration example of the cooling component 1 of the present example embodiment. Fig. 2 is a view taken along a line A-A in Fig. 1 as viewed in a direction of an arrow A-A.

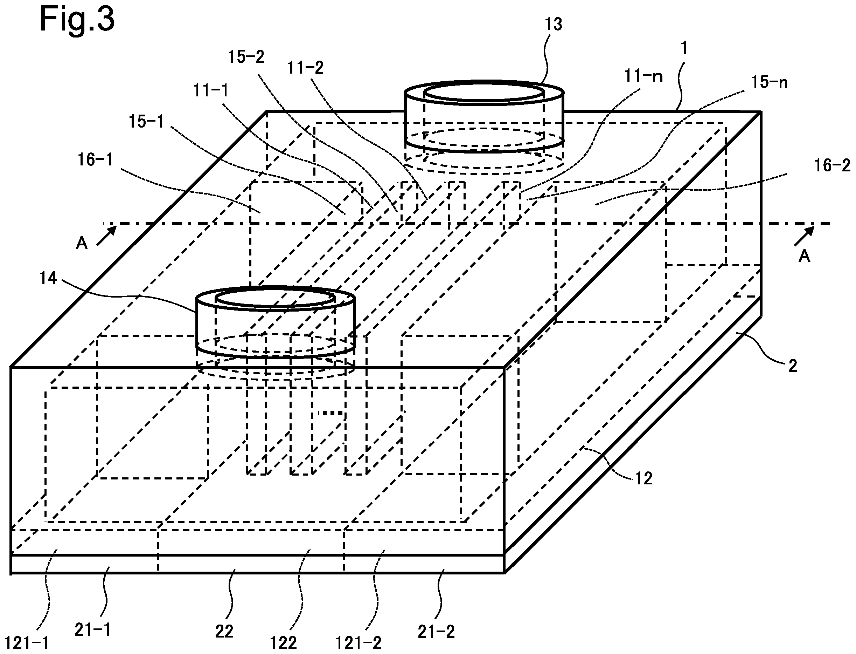

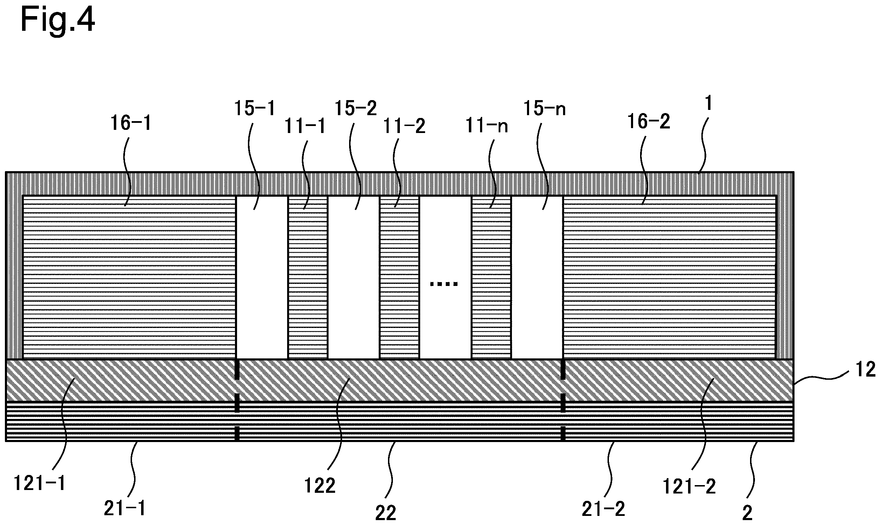

Fig. 3 is the transparent perspective view illustrating the configuration example of the cooling component 1 and a heating body 2 of the present example embodiment. Fig. 4 is the cross-sectional view illustrating the configuration example of the cooling component 1 and the heating body 2 of the present example embodiment. Fig. 4 is a view taken along the line A-A in Fig. 3 as viewed in a direction of the arrow A-A.

As illustrated in Fig. 3 and Fig. 4, the heating body 2 cooled by the cooling component 1 of the present example embodiment includes first regions 21-1 and 21-2 and a second region 22 having a higher temperature than each of the first regions 21-1 and 21-2. It can also be said that each of the first regions 21-1 and 21-2 of the heating body 2 is a region having a lower temperature than the second region 22 of the heating body 2.

The cooling component 1 includes a first portion 121-1 related to the first region 21-1 of the heating body 2 and a first portion 121-2 related to the first region 21-2 of the heating body 2. The cooling component 1 also includes a second portion 122 related to the second region 22 of the heating body 2. The second portion 122 of the cooling component 1 includes a plurality of protruding sections 11-1 to 11-n to be described later, and each of the plurality of protruding sections 11-1 to 11-n of the second portion 122 forms flow passages 15-1 to 15-n through which a cooling medium (the refrigerant) passes. No flow passage is provided in the first portion 121-1 and the first portion 121-2 of the cooling component 1.

Specifically, the cooling component 1 includes a heat receiving plate 12. To relate to a predetermined region of the heating body 2 means, for example, to directly face or face and come into contact with the predetermined region of the heating body 2, or to face or face and come into contact with the predetermined region of the heating body 2 via an inclusion. The heat receiving plate 12 constitutes a part of each of the first portions 121-1 and 121-2 and the second portion 122 of the present example embodiment. In other words, two portions at both ends of the three portions divided by the two broken lines illustrated in Fig. 2 are included in the first portions 121-1 and 121-2, and the other portion (a central portion) of the three divided portions is included in the second portion 122.

As illustrated in Fig. 1 to Fig. 4, the second portion 122 of the cooling component 1 includes the plurality of protruding sections 11-1, 11-2,..., 11-n (n is an integer of 2 or more) arranged at regular intervals.

For example, each of the protruding sections 11-1 to 11-n is a thin plate-shaped protruding section. Bottom surfaces of the protruding sections 11-1 to 11-n are in contact with the second portion 122 of the heat receiving plate 12. Upper surfaces of the protruding sections 11-1 to 11-n are in contact with an upper surface of the cooling component 1. The protruding sections 11-1 to 11-n may be formed integrally with the heat receiving plate 12. In a case where the protruding sections 11-1 to 11-n are formed integrally with the heat receiving plate 12, the heat receiving plate 12 is a base of the heat sink, and the protruding sections 11-1 to 11-n constitute the fins of the heat sink.

Each of the plurality of protruding sections 11-1 to 11-n of the second portion 122 forms flow passages 15-1, 15-2,..., 15-n (n is an integer of 1 or more) through which the refrigerant passes. The bottom of each of the flow passages 15-1 to 15-n is the second portion 122 of the heat receiving plate 12. The flow passages 15-1 to 15-n are formed by side surfaces of the protruding sections 11-1 to 11-n.

The refrigerant is supplied from a supply port 13 formed on the upper surface of the cooling component 1 to each of the flow passages 15-1 to 15-n. Specifically, the refrigerant is supplied to a space formed in a lower portion of the supply port 13, and the refrigerant flows from the space toward each of the flow passages 15-1 to 15-n. The refrigerant having passed through each of the flow passages 15-1 to 15-n flows into the space below a discharge port 14. The refrigerant having flowed into the space below the discharge port 14 is discharged to outside of the cooling component 1 from the discharge port 14 formed in the upper surface of the cooling component 1.

The heating body 2 is, for example, a central processing unit (CPU). Alternatively, the heating body 2 may be an LSI constituting the CPU. The heating body 2 may be a memory and the CPU. For example, it is assumed that each of the first regions 21-1 and 21-2 of the heating body 2 is mainly constituted by a circuit having a heat generation temperature lower than that of the second region 22. For example, it is assumed that the second region 22 of the heating body 2 is mainly constituted by a circuit having a higher heat generation temperature than each of the first regions 21-1 and 21-2. As described above, it is assumed that the heating body 2 is a heating body that needs to efficiently cool the second region 22.

The refrigerant (the cooling medium) that receives heat from the heating body 2 flows between each of the protruding sections 11-1 to 11-n. The refrigerant is, for example, water. In the example of the cooling component 1 illustrated in Fig. 1 to Fig. 4, heat generated from the heating body 2 is transferred to the heat receiving plate 12, and is transferred from the heat receiving plate 12 to each of the protruding sections 11-1 to 11-n and any of the refrigerant. The heat transferred to any one of the protruding sections 11-1 to 11-n is also transferred to the refrigerant flowing through any one of the flow passages 15-1 to 15-n. An interval at which each of the protruding sections 11-1 to 11-n is provided, that is, a width of each of the flow passages 15-1 to 15-n is a length in a lateral direction of a white portion between the protruding sections 11-1 and 11-n in Fig. 2 and Fig. 4.

As illustrated in Fig. 1 to Fig. 4, the first portion 121-1 of the cooling component 1 includes a block 16-1. Similarly, the first portion 121-2 of the cooling component 1 includes a block 16-2. As described above, no flow passage is provided in each of the first portions 121-1 and 121-2 of the cooling component 1. The bottom surface of each of the blocks 16-1 and 16-2 is in contact with the heat receiving plate 12. Each of the blocks 16-1 and 16-2 may be formed integrally with the heat receiving plate 12. The upper surfaces of the blocks 16-1 and 16-2 are in contact with the upper surface of the cooling component 1. The side surfaces of the blocks 16-1 and 16-2 may be in contact with an inner peripheral wall forming an inner side surface of the cooling component 1. The flow passage 15-1 is formed between the block 16-1 and the protruding section 11-1, and the flow passage 15-n is formed between the block 16-2 and the protruding section 11-n.

As described above, in the first example embodiment of the present invention, the cooling component 1 includes the first portion 121-1 and the first portion 121-2 related to each of the first regions 21-1 and 21-2 of the heating body 2. The cooling component 1 also includes the second portion 122 related to the second region 22 of the heating body 2, which is higher in temperature than that of each of the first regions 21-1 and 21-2. The cooling component 1 includes the plurality of protruding sections 11-1 to 11-n in the second portion 122. In the cooling component 1, each of the plurality of protruding sections 11-1 to 11-n of the second portion 122 forms the flow passages 15-1 to 15-n through which the refrigerant passes. No flow passage is provided in each of the first portions 121-1 and 121-2 of the cooling component 1. As a result, the second portion 122 of the cooling component 1 is cooled by the refrigerant passing through each of the flow passages 15-1 to 15-n formed by each of the plurality of protruding sections 11-1 to 11-n. Since no flow passage is provided in each of the first portions 121-1 and 121-2, the refrigerant can pass through only each of the flow passages 15-1 to 15-n. As a result, the cooling component 1 can efficiently cool the second region 22 having a higher temperature than each of the first region 21-1 and the first region 21-2 of the heating body 2. As described above, the cooling component 1 can efficiently cool the portion of the heating body 2 that generates heat at a higher temperature without increasing the area of the heat sink.

### [Comparison between first example embodiment and comparative example]

A cooling component (not illustrated) of the comparative example is different from the cooling component 1 of the first example embodiment illustrated in Fig. 1 to Fig. 4 in that the flow passage is provided in the first portion and the second portion. A configuration of the heating body used in the comparative example is similar to a configuration of the heating body 2 of the first example embodiment illustrated in Fig. 3 to Fig. 4.

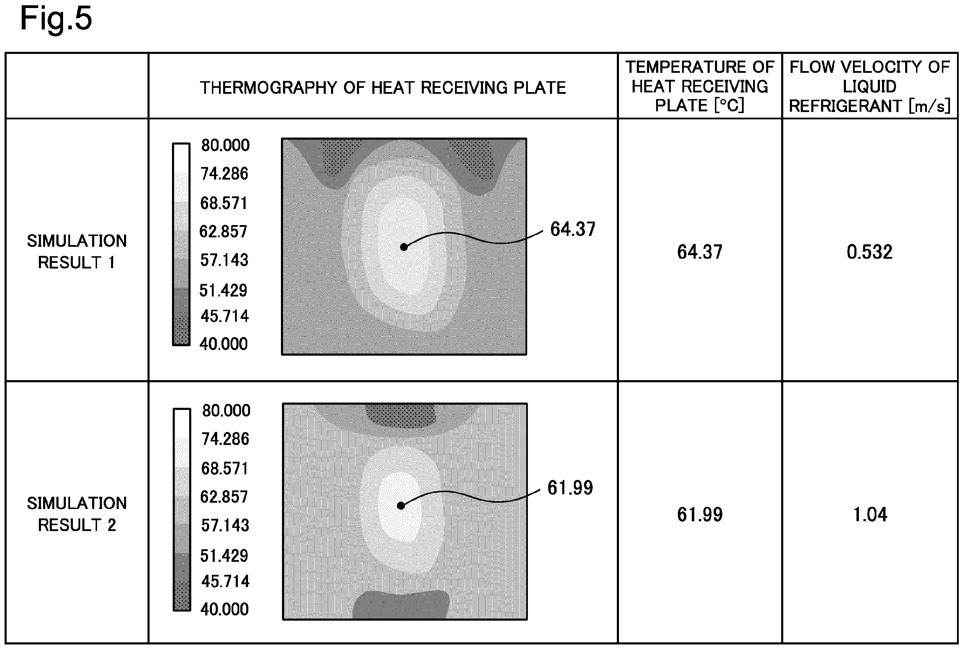

With reference to Fig. 5, the simulation results of the cooling component 1 of the present example embodiment and the cooling component of the comparative example will be described. Fig. 5 is the diagram illustrating the example of the simulation results of the cooling component 1 of the example embodiment and the cooling component of the comparative example. The cooling component of the comparative example is configured similarly to the cooling component described in PTL 1. Specifically, in the cooling component of the comparative example, the flow passage provided in the second portion in the cooling component of the present example embodiment is provided in the first portion and the second portion.

A simulation result 1 illustrated in Fig. 5 is a simulation result of cooling of the heating body 2 of the cooling component of the comparative example. A simulation result 2 illustrated in Fig. 5 is a simulation result of cooling of the heating body 2 of the cooling component 1. Each of the simulation result 1 and the simulation result 2 is a simulation result in a case where the same amount of liquid refrigerant flows at a constant temperature in order to cool the heating body 2 in which the temperature of the central portion is higher than that of an end portion. Fig. 5 illustrates thermography of the heat receiving plate of the cooling component 1 and each of the cooling component of the comparative example, a temperature of the heat receiving plate, and a flow velocity of the liquid refrigerant.

As illustrated in Fig. 5, a temperature of the central portion of the heat receiving plate 12 of the cooling component 1 is 61.99°C, and a temperature of the central portion of the heat receiving plate of the cooling component of the comparative example is 64.37°C. As also shown in thermography, the temperature of the central portion of the heating body 2 is lower in the cooling component 1 than in the cooling component of the comparative example in which the flow passage is provided in the first portion and the second portion. The reason for this is that in the cooling component 1 of the present example embodiment, since the flow passage is not provided in each of the first portions 121-1 and 121-2, the flow velocity of the refrigerant flowing through the flow passage of the second portion increases. This is because a larger amount of liquid refrigerant can flow in the second portion 122 than in the cooling component of the comparative example as a result of the increased flow velocity.

In the cooling component 1, no flow passage is provided in each of the first portions 121-1 and 121-2. As a result, in a case where the cooling component 1 and the cooling component of the comparative example are cooled with the same amount of liquid refrigerant, the flow velocity of the liquid refrigerant becomes faster in the cooling component 1 than in the cooling component of the comparative example, and a flow rate increases. Since the flow velocity of the liquid refrigerant is higher in the cooling component 1 than that in the cooling component of the comparative example, the liquid refrigerant having received heat from the heat receiving plate 12 can be removed from inside of the cooling component faster than in the cooling component of the comparative example. Therefore, the cooling component 1 can more efficiently cool the portion of the heating body 2 that generates heat at a higher temperature than the cooling component of the comparative example.

For example, in the cooling component of the comparative example, in a case where a portion of the heating body 2 that generates heat at a higher temperature is cooled, the cooling medium also flows to the first portion, and thus the cooling medium flowing to the second portion is reduced accordingly. Therefore, the flow rate of the liquid refrigerant passing through the second portion of the cooling component of the comparative example is smaller than the flow rate of the liquid refrigerant passing through the second portion 122 of the cooling component 1 of the present example embodiment. In a case of the cooling component of the comparative example, it is also possible to increase a cooling effect of the second portion by increasing the flow rate of the liquid refrigerant, but for this purpose, it is necessary to change cooling equipment including equipment for supplying the liquid refrigerant to the cooling component. Therefore, the flow rate of the liquid refrigerant cannot be easily increased. On the other hand, the cooling component 1 of the present example embodiment can more efficiently cool the portion of the heating body 2 that generates heat at a higher temperature than the cooling component of the comparative example. Therefore, in the cooling component of the comparative example, even in the heating body 2 in which it is necessary to increase the flow rate of the liquid refrigerant or to change the equipment, the cooling component 1 can be cooled without increasing the flow rate of the liquid refrigerant in some cases.

### [First modification of first example embodiment]

In the cooling component of the first modification of the first example embodiment, in the heating body 2, at least one of the interval and a thickness of the protruding sections 11-1 to 11-n provided in the second portion 122 is not uniform. For example, a designer of the cooling component can set at least one of the interval and the thickness of the protruding sections 11-1 to 11-n provided in the second portion 122 to any size in the heating body 2. The designer of the cooling component may perform a simulation of cooling the heating body 2 using the cooling component provided with the plurality of protruding sections having different intervals and different thicknesses. Then, the designer of the cooling component may mount, in an information processing apparatus, the cooling component that exhibits desirable performance in the simulation among the plurality of cooling components having different at least one of the interval or the thickness of the protruding section.

The designer of the cooling component can acquire temperature distribution of the heating body by any method. For example, the designer of the cooling component may acquire the temperature distribution of the heating body by performing simulation. The designer of the cooling component may acquire or estimate the temperature distribution of the heating body from specification information of the heating body. As described above, the cooling component is designed based on the temperature distribution of the heating body.

### [Second modification of first example embodiment]

Fig. 3 and Fig. 4 illustrate a configuration example in which the heat receiving plate 12 of the cooling component 1 is in contact with the heating body 2. However, in the second modification of the first example embodiment, the heat receiving plate 12 of the cooling component 1 is not in contact with the heating body 2. For example, a predetermined space or a heat conductive material may be provided between the heat receiving plate 12 of the cooling component 1 and the heating body 2.

Since Fig. 3 and Fig. 4 illustrate the configuration examples in a case where the cooling component 1 is in contact with the heating body 2, "related to a predetermined region of the heating body 2" means that the cooling component 1 faces or faces and comes into contact with the predetermined region of the heating body 2. However, in the second modification of the first example embodiment, the heat receiving plate 12 of the cooling component 1 is not in contact with the heating body 2. As described above, "related to the predetermined region of the heating body 2" may mean facing or facing and coming into contact with the predetermined region of the heating body 2 via the inclusion. The inclusion is, for example, air that fills a predetermined space between the heat receiving plate 12 and the heating body 2. Alternatively, the inclusion is a thermally conductive material.

### [Third modification of first example embodiment]

Fig. 1 to Fig. 4 illustrate a configuration example in a case where the supply port 13 is provided on the upper surface of the cooling component 1, but a position or a shape at which the supply port 13 of the third modification of the first example embodiment is provided is different from the position or the shape illustrated in Fig. 1 to Fig. 4. The supply port 13 can be provided at any position where the refrigerant can be supplied to each of the flow passages 15-1 to 15-n. Fig. 1 to Fig. 4 illustrate the configuration examples in which the shape of the supply port 13 is a cylindrical shape and a hollow cylindrical shape, but the shape of the supply port 13 is not limited to the shapes illustrated in Fig. 1 to Fig. 4. The cooling component 1 is provided with the supply port 13 having any shape.

### [Fourth modification of first example embodiment]

Fig. 1 to Fig. 4 illustrate the configuration examples in a case where the discharge port 14 is provided on the upper surface of the cooling component 1, but a position or a shape in which the discharge port 14 of the fourth modification of the first example embodiment is provided is different from the position or the shape illustrated in Fig. 1 to Fig. 4. The discharge port 14 can be provided at any position where the refrigerant having passed through each of the flow passages 15-1 to 15-n can be discharged. Fig. 1 to Fig. 4 illustrate the configuration examples in which the shape of the discharge port 14 is the cylindrical shape and the hollow cylindrical shape, but the shape of the discharge port 14 is not limited to the shapes illustrated in Fig. 1 to Fig. 4. The cooling component 1 is provided with the discharge port 14 having any shape.

### [Second example embodiment]

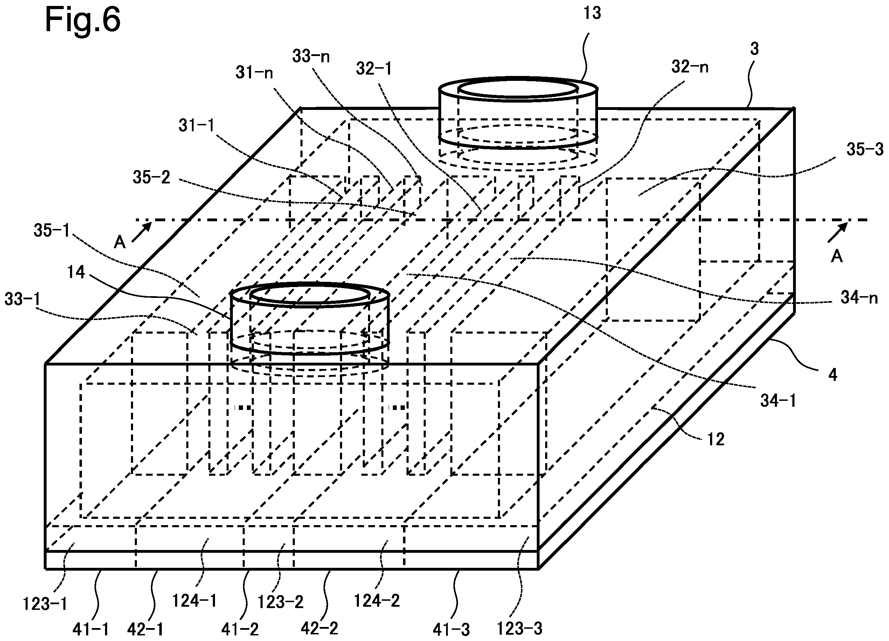

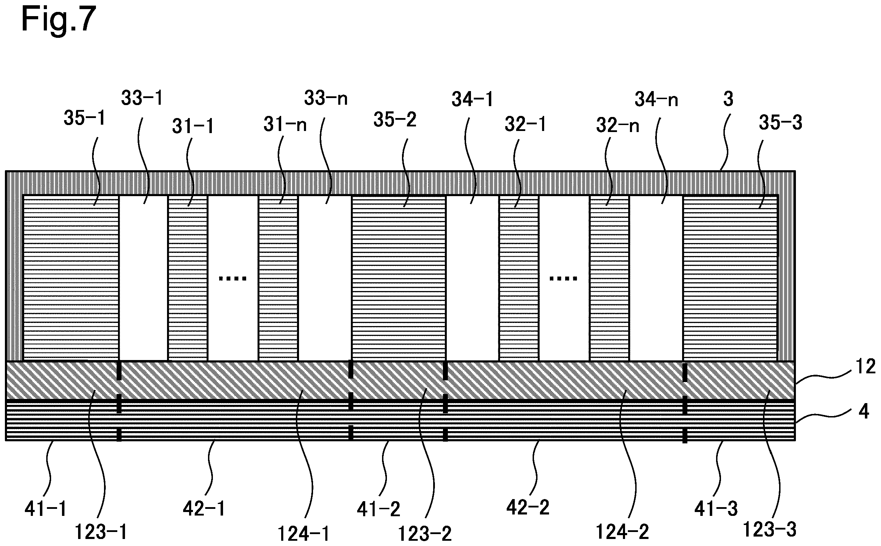

A cooling component 3 according to the second example embodiment of the present invention will be described with reference to Fig. 6 and Fig. 7.

Fig. 6 is the transparent perspective view illustrating the configuration example of the cooling component 3 and the heating body 4 of the present example embodiment. Fig. 7 is the cross-sectional view illustrating the configuration example of the cooling component 3 and the heating body 4 of the present example embodiment. Fig. 7 is a view taken along the line A-A in Fig. 6 as viewed in the direction of the arrow A-A.

As illustrated in Fig. 6 and Fig. 7, the cooling component 3 of the second example embodiment includes a first portion 123-1 related to a first region 41-1 of the heating body 4, a first portion 123-2 related to a first region 41-2, and a first portion 123-2 related to a first region 41-3. The cooling component 3 also includes a second portion 124-1 related to the second region 42-1 and the second portion 124-2 related to the second region 42-2, which are higher in temperature than the first region (in the present example embodiment, the first regions 41-1, 41-2, and 41-3) of the heating body 4. The second portion 124-1 of the cooling component 3 includes a plurality of protruding sections 31-1,..., 31-n (n is an integer of 2 or more). The heating body 4 will be described later. Then, the second portion 124-2 of the cooling component 3 includes a plurality of protruding sections 32-1,..., 32-n (n is an integer of 2 or more). As described above, the cooling component 3 according to the second example embodiment is different from the cooling component 1 according to the first example embodiment illustrated in Fig. 1 to Fig. 4 in that, in a case where the heating body 4 has the plurality of second regions 42-1 and 42-2, each of the second portions 124-1 and 124-2 related to each of the second regions 42-1 and 42-2 includes a plurality of protruding sections (in the present example embodiment, the protruding sections 31-1 to 31-n and the protruding sections 32-1 to 32-n).

Each of the plurality of protruding sections 31-1 to 31-n of the second portion 124-1 forms flow passages 33-1 to 33-n (n is an integer of 1 or more) through which the refrigerant passes. Each of the plurality of protruding sections 32-1 to 32-n of the second portion 124-2 forms flow passages 34-1 to 34-n (n is an integer of 1 or more) through which the refrigerant passes. Since the configurations of the protruding sections 31-1 to 31-n and the protruding sections 32-1 to 32-n are similar to the configurations of the protruding sections 11-1 to 11-n illustrated in Fig. 1 to Fig. 4, common descriptions will be omitted. Since the configurations of the flow passages 33-1 to 33-n and the flow passages 34-1 to 34-n are similar to the configurations of the flow passages 15-1 to 15-n illustrated in Fig. 1 to Fig. 4, the common descriptions will be omitted.

As illustrated in Fig. 6 and Fig. 7, the cooling component 3 includes a block 35-1 in the first portion 123-1. The cooling component 3 includes a block 35-2 in the first portion 123-2. The cooling component 3 includes a block 35-3 in the first portion 123-3. Since the configurations of the blocks 35-1, 35-2, and 35-3 are similar to the configurations of the blocks 16-1 and 16-2 of the cooling component 1 illustrated in Fig. 1 to Fig. 4, the descriptions thereof will be omitted.

The cooling component 3 is, for example, a cold plate for water cooling. Since water has a larger heat transport amount per unit weight than air, the cooling component 3 using water as the refrigerant can efficiently cool the heating body 4 as compared with a case of air cooling. For example, the cooling component 3 is mounted in the information processing apparatus in order to cool the heating body of the information processing apparatus. Specifically, the cooling component 3 is installed so as to be close to the CPU or the LSI constituting the CPU. In a case where the CPU is mounted on the substrate, the memory may be mounted on the same substrate as the CPU.

Fig. 6 and Fig. 7 illustrate the configuration examples of the cooling component 3 in a case where the interval at which each of the protruding sections 31-1 to 31-n is provided and the interval at which each of the protruding sections 32-1 to 32-n is provided are the same interval. In other words, the widths of the flow passages 33-1 to 33-n and the widths of the flow passages 34-1 to 34-n are the same. The interval at which each of the protruding sections 31-1 to 31-n is provided is, for example, the length in the lateral direction of the white portion between the protruding sections 31-1 and 31-n illustrated in Fig. 7. The interval at which each of the protruding sections 32-1 to 32-n is provided is, for example, the length in the lateral direction of the white portion between the protruding sections 32-1 and 32-n illustrated in Fig. 7. The interval at which each of the protruding sections 31-1 to 31-n is provided may be different from the interval at which each of the protruding sections 32-1 to 32-n is provided. A case where the interval at which each of the protruding sections 31-1 to 31-n is provided is different from the interval at which each of the protruding sections 32-1 to 32-n is provided will be described in detail in the first modification of the present example embodiment.

The refrigerant flows through the white portion in the cooling component 3 illustrated in Fig. 7. The white portion in the cooling component 3 illustrated in Fig. 7 is a flow passage formed by each of the protruding sections 31-1 to 31-n and any one of the protruding sections 32-1 to 32-n.

Fig. 6 and Fig. 7 illustrate the configuration examples of the cooling component 3 in a case where the thickness of each of the protruding sections 31-1 to 31-n is the same as the thickness of each of the protruding sections 32-1 to 32-n. The thickness of each of the protruding sections 31-1 to 31-n is, for example, the length in the lateral direction of the cross-sectional view of the protruding section 31-1 illustrated in Fig. 7. The thickness of each of the protruding sections 32-1 to 32-n is, for example, the length in the lateral direction of the cross-sectional view of the protruding section 32-1 illustrated in Fig. 7. The thickness of each of the protruding sections 31-1 to 31-n may be different from the thickness of each of the protruding sections 32-1 to 32-n. A case where the thickness of each of the protruding sections 31-1 to 31-n is different from the thickness of each of the protruding sections 32-1 to 32-n will be described in detail in the second modification of the present example embodiment.

The cooling component 3 may include a second portion in which the protruding section is not provided among the second portions related to two or more second regions.

The designer of the cooling component can set at least one of the interval and the thickness of the protruding section provided in each of the second portions related to the second region to any size. As described in the first modification of the first example embodiment, for example, the designer of the cooling component may perform a simulation of cooling the heating body 4 using the cooling component in which the plurality of protruding sections having different thicknesses and different intervals is provided in each of the second portions. Then, the designer of the cooling component may mount, in an information processing apparatus, the cooling component that exhibits desirable performance in the simulation among the plurality of cooling components having different at least one of the interval or the thickness of the protruding section.

The refrigerant that receives heat from the heating body 4 passes through each of the flow passages 33-1 to 33-n and each of the flow passages 34-1 to 34-n. The refrigerant flows through the white portion in the cooling component 3 illustrated in Fig. 7. In the example of the cooling component 3 illustrated in Fig. 6 and Fig. 7, the heat generated from the heating body 4 is transferred to the heat receiving plate 12 to be described later. Further, the heat transferred to the heat receiving plate 12 is transferred from the heat receiving plate 12 to any one of the protruding sections 31-1 to 31-n, the protruding sections 32-1 to 32-n, and the refrigerant. The heat transferred to each of the protruding sections 31-1 to 31-n and any one of the protruding sections 32-1 to 32-n is also transferred to the refrigerant passing through each of the flow passages 33-1 to 33-n and any one of the flow passages 34-1 to 34-n.

The refrigerant is supplied from the supply port 13 to each of the flow passages 33-1 to 33-n and each of the flow passages 34-1 to 34-n. The refrigerant having passed through each of the flow passages 33-1 to 33-n and each of the flow passages 34-1 to 34-n is discharged from the discharge port 14 to the outside of the cooling component 3.

Since the heat receiving plate 12 of the cooling component 3 has the same configuration as the heat receiving plate 12 of the cooling component 1 in the first example embodiment, related components are denoted by the same reference numerals as those in Fig. 1 to Fig. 4, and the common descriptions thereof will be omitted. The heat receiving plate 12 constitutes a part of each of the first portion 123-1, 123-2, and 123-3 and the second portion 124-1 and 124-2. In other words, of the five portions divided by the four broken lines illustrated in Fig. 7, each of two portions at both ends and a central portion is included in the first portion 123-1, 123-2, and 123-3, and each of the other two portions of the five divided portions is included in the second portions 124-1 and 124-2. The heat receiving plate 12 may be formed integrally with the protruding sections 31-1 to 31-n and protruding sections 32-1 to 32-n. The heat receiving plate 12 may be formed integrally with the blocks 35-1, 35-2, and 35-3.

Since the supply port 13 and the discharge port 14 are similar to the configurations of the supply port 13 and the discharge port 14 of the cooling component 1 in the first example embodiment, the related components are denoted by the same reference numerals as those in Fig. 1 to Fig. 4, and the descriptions thereof are omitted.

In the second example embodiment, the second region 42-1 of the heating body 4 may be higher in temperature than any of the first region 41-1, the first region 41-2, and the first region 41-3, or may be higher in temperature than the first region 41-1 and the first region 41-2 to which the second region 42-1 is adjacent. The second region 42-2 may be higher in temperature than any of the first region 41-1, the first region 41-2, and the first region 41-3, or may be higher in temperature than the first region 41-2 and the first region 41-3 to which the second region 42-2 is adjacent. As described above, the second region (in the present example embodiment, for example, the second region 42-1) is a region having a higher temperature than at least any one of the first regions 41-1 and 41-2 and the first region 41-3.

As described above, in the second example embodiment of the present invention, the cooling component 3 includes the first portion 123-1, the first portion 123-2, and the first portion 123-3 related to each of the first regions 41-1, 41-2, and 41-3 of the heating body 4. The cooling component 3 also includes the second portion 124-1, and the second portion 124-2 related to each of the second regions 42-1 and 42-2 of the heating body 4, that are higher in temperature than each of the first regions 41-1, 41-2, and 41-3. The cooling component 3 includes the plurality of protruding sections 31-1 to 31-n and the plurality of protruding sections 32-1 to 32-n in each of the second portions 124-1 and 124-2. In the cooling component 3, each of the plurality of protruding sections 31-1 to 31-n of the second portion 124-1 forms flow passages 33-1 to 33-n through which the refrigerant passes. In the cooling component 3, each of the plurality of protruding sections 32-1 to 32-n of the second portion 124-2 forms flow passages 34-1 to 34-n. No flow passage is provided in each of the first portions 123-1, 123-2, and 123-3 of the cooling component 3. As a result, each of the second portions 124-1 and 124-2 of the cooling component 3 is cooled by the refrigerant passing through each of the flow passages 33-1 to 33-n and each of the flow passages 34-1 to 34-n. Since no flow passage is provided in each of the first portions 123-1, 123-2, and 123-3, the refrigerant can pass only through each of the flow passages 33-1 to 33-n and each of the flow passages 34-1 to 34-n. As a result, the cooling component 3 can efficiently cool the second regions 42-1 and 42-2 having a higher temperature than each of the first regions 41-1, 41-2, and 41-3 of the heating body 4. As described above, the cooling component 3 can efficiently cool the portion of the heating body 4 that generates heat at a higher temperature without increasing the area of the heat sink.

The cooling component 3 of the present example embodiment includes the plurality of protruding sections 31-1 to 31-n and a plurality of protruding sections 32-1 to 32-n in each of the second portions 124-1 and 124-2 related to the second regions 42-1 and 42-2 in the heating body 4. As a result, this makes it possible to efficiently cool each of the plurality of second regions 42-1 and 42-2 in the heating body 4.

### [First modification of second example embodiment]

In the cooling component of the first modification of the present example embodiment, the interval at which each of the protruding sections 31-1 to 31-n is provided is different from the interval at which each of the protruding sections 32-1 to 32-n is provided. In the cooling component of the present modification, in the heating body 4, each of the second portions 124-1 and 124-2 related to the plurality of second regions 42-1 and 42-2 is provided with a protruding section having a different interval. Since the interval at which each of the protruding sections 31-1 to 31-n is provided is different from the interval at which each of the protruding sections 32-1 to 32-n is provided, the second region 42-1 of the heating body 4 is cooled by the cooling component of the present modification with an efficiency different from that of the second region 42-2.

### [Second modification of second example embodiment]

In the cooling component of the second modification of the present example embodiment, the thickness of each of the protruding sections 31-1 to 31-n is different from the thickness of each of the protruding sections 32-1 to 32-n. In the cooling component of the present modification, in the heating body 4, protruding sections having different thicknesses are provided in each of the second portions 124-1 and 124-2 related to the plurality of second regions 42-1 and 42-2. Since the thickness of each of the protruding sections 31-1 to 31-n is different from the thickness of each of the protruding sections 32-1 to 32-n, the second region 42-1 of the heating body 4 is cooled by the cooling component of the present modification with an efficiency different from that of the second region 42-2.

### [Third example embodiment]

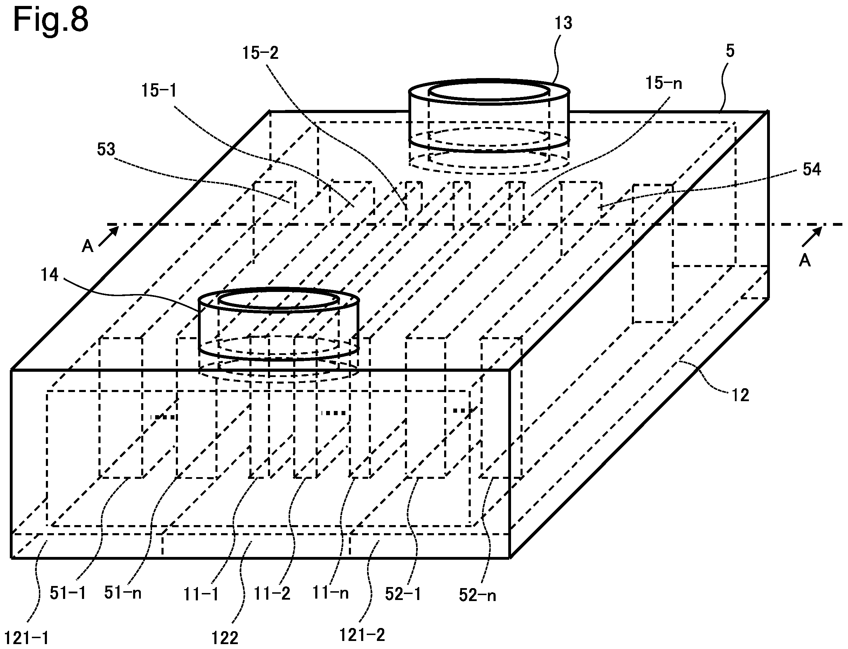

A cooling component 5 according to the third example embodiment of the present invention will be described with reference to Fig. 8 to Fig. 11.

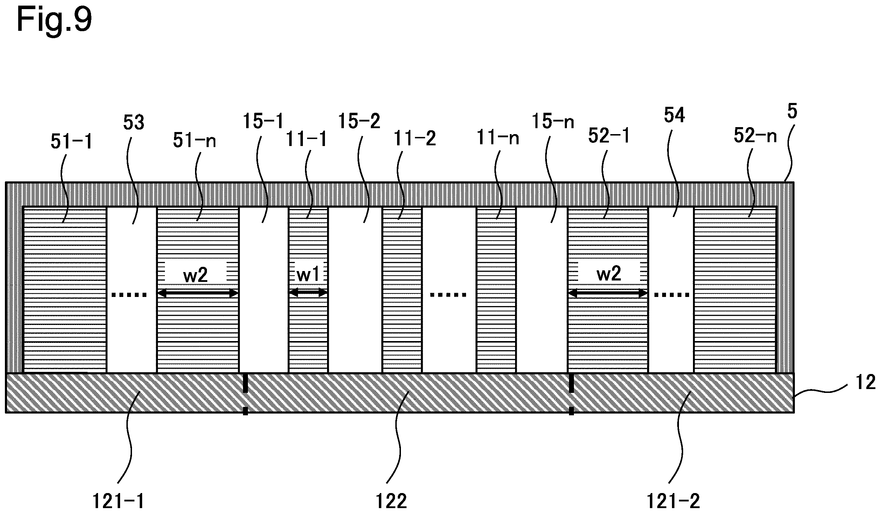

Fig. 8 is the transparent perspective view illustrating the configuration example of the cooling component 5 of the present example embodiment. Fig. 9 is the cross-sectional view illustrating the configuration example of the cooling component 5 of the present example embodiment. Fig. 9 is a view taken along the line A-A in Fig. 8 as viewed in the direction of the arrow A-A.

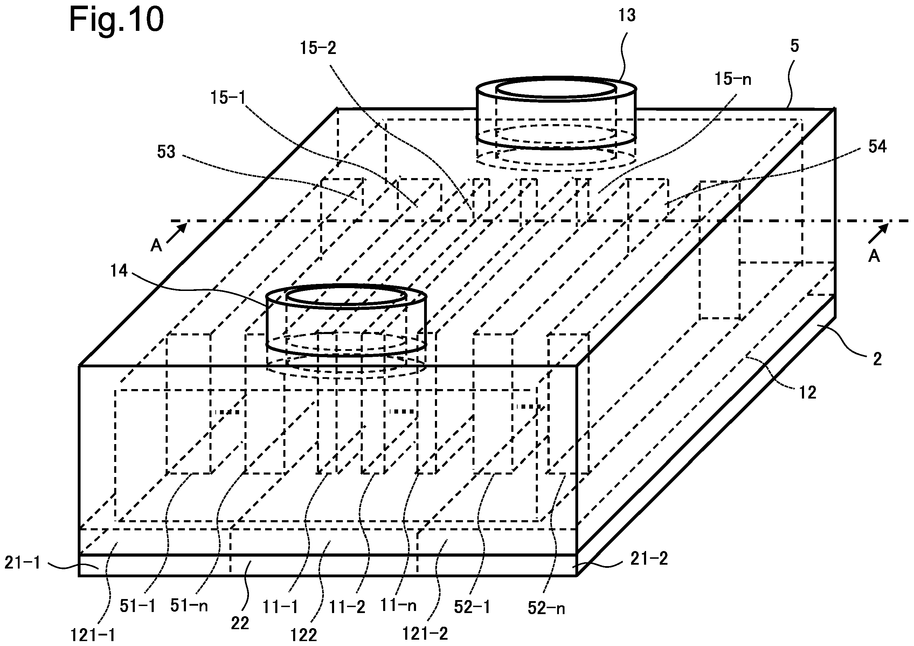

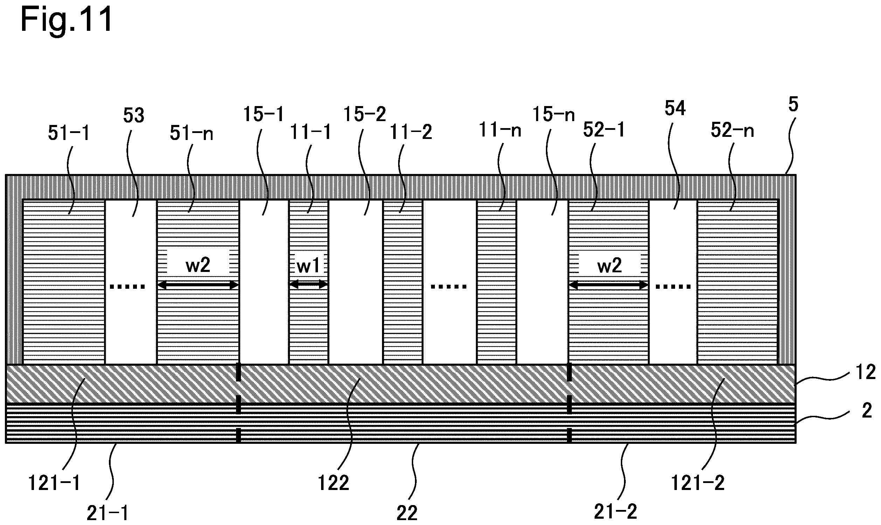

Fig. 10 is the transparent perspective view illustrating the configuration example of the cooling component 5 and the heating body 2 of the present example embodiment. Fig. 11 is the cross-sectional view illustrating the configuration example of the cooling component 5 and the heating body 2 of the present example embodiment. Fig. 11 is the view taken along the line A-A in Fig. 10 as viewed in the direction of the arrow A-A.

Since the heating body 2 of the present example embodiment has the same configuration as that of the heating body 2 of the first example embodiment, related components are denoted by the same reference numerals as those in Fig. 3 and Fig. 4, and the descriptions thereof are omitted.

As illustrated in Fig. 8 to Fig. 11, the cooling component 5 of the third example embodiment includes a plurality of protruding sections 51-1,..., 51-n (n is an integer of 2 or more) in the first portion 121-1 related to the first region 21-1 of the heating body 2. Then, the cooling component 5 of the third example embodiment includes a plurality of protruding sections 52-1,..., 52-n (n is an integer of 2 or more) in the first portion 121-2 related to the first region 21-2 of the heating body 2. As described above, the cooling component 5 of the third example embodiment is different from the cooling component 1 of the first example embodiment illustrated in Fig. 1 to Fig. 4 and the cooling component 3 of the second example embodiment illustrated in Fig. 6 and Fig. 7 in that, each of the first portions 121-1 and 121-2 related to the first regions 21-1 and 21-2 of the heating body 2 includes the protruding sections 51-1 to 51-n and the protruding sections 52-1 to 52-n.

Since the configurations of the protruding sections 11-1, 11-2,..., 11-n (n is an integer of 2 or more), the flow passages 15-1, 15-2,..., 15-n (n is an integer of 1 or more) formed by the protruding sections 11-1 to 11-n, the heat receiving plate 12, the supply port 13, and the discharge port 14 are similar to each configuration of the cooling component 1 in the first example embodiment, the related components are denoted by the same reference numerals as those in Fig. 1 to Fig. 4, and the common descriptions are omitted.

As illustrated in Fig. 8 to Fig. 11, each of the first portion 121-1 related to the first region 21-1 of the heating body 2 and the first portion 121-2 related to the first region 21-2 of the heating body 2 includes the protruding sections 51-1 to 51-n and the protruding sections 52-1 to 52-n n thicker than the plurality of protruding sections 11-1 to 11-n of the second portion 122 related to the second region 22 of the heating body 2. As illustrated in Fig. 9 and Fig. 11, the thickness of each of the protruding sections 11-1 to 11-n is W1, and the thickness of each of the plurality of protruding sections 51-1 to 51-n and the protruding sections 52-1 to 52-n is W2. As illustrated in Fig. 9 and Fig. 11, W2 is longer than W1.

The cooling component 5 includes the protruding sections 51-1 to 51-n in the first portion 121-1 related to the first region 21-1 of the heating body 2. The protruding sections 51-1 to 51-n form one or two or more flow passages 53. The cooling component 5 includes protruding sections 52-1 to 52-n in the first portion 121-2 related to the first region 21-2 of the heating body 2. The protruding sections 52-1 to 52-n form one or two or more flow passages 54. Since the configurations of the flow passage 53 and the flow passage 54 are similar to the configurations of the flow passages 15-1 to 15-n, the descriptions thereof will be omitted. The refrigerant passes through each of the flow passages 15-1 to 15-n, the flow passage 53, and the flow passage 54.

In a case where there are two or more first regions in the heating body, there may be a first portion that does not include the protruding section among the first portions related to the two or more first regions.

The refrigerant is, for example, water. In the example of the cooling component 5 illustrated in Fig. 8 to Fig. 11, the heat generated from the heating body 2 is transferred to the heat receiving plate 12. The heat transferred to the heat receiving plate 12 is transferred from the heat receiving plate 12 to any one of the protruding sections 11-1 to 11-n, any one of the protruding sections 51-1 to 51-n, any one of the protruding sections 52-1 to 52-n, and the refrigerant. The heat transferred to any one of the protruding sections 11-1 to 11-n, any one of the protruding sections 51-1 to 51-n, and any one of the protruding sections 52-1 to 52-n is also transferred to the refrigerant passing through any one of the flow passages 15-1 to 15-n, the flow passage 53, and the flow passage 54.

The refrigerant is supplied from the supply port 13 to the flow passages 15-1 to 15-n, the flow passage 53, and the flow passage 54. The refrigerant that has passed through any of the flow passages 15-1 to 15-n, the flow passage 53, and the flow passage 54 is discharged from the discharge port 14 to the outside of the cooling component 5.

As described above, in the third example embodiment of the present invention, the cooling component 5 includes the first portion 121-1 and the first portion 121-2 related to each of the first regions 21-1 and 21-2 of the heating body 2. The cooling component 5 also includes the second portion 122 related to the second region 22 of the heating body 2, which is higher in temperature than each of the first regions 21-1 and 21-2. The cooling component 5 includes the plurality of protruding sections 11-1 to 11-n in the second portion 122. The cooling component 5 includes, in each of the first portions 121-1 and 121-2, the plurality of protruding sections 51-1 to 51-n and 52-1 to 52-n thicker than the plurality of protruding sections 11-1 to 11-n of the second portion 122. In the cooling component 5, each of the plurality of protruding sections 11-1 to 11-n of the second portion 122 forms flow passages 15-1 to 15-n through which the refrigerant passes. In the cooling component 5, the plurality of protruding sections 51-1 to 51-n of the first portion 121-1 form the flow passage 53 through which the refrigerant passes. In the cooling component 5, the plurality of protruding sections 52-1 to 52-n of the first portion 121-2 form the flow passage 54 through which the refrigerant passes. The cooling component 5 includes, in each of the first portions 121-1 and 121-2, the plurality of protruding sections 51-1 to 51-n and the plurality of protruding sections 52-1 to 52-n thicker than the plurality of protruding sections 11-1 to 11-n of the second portion 122. As a result, the flow rate of the refrigerant flowing per unit area of the second portion 122 related to the second region 22 is larger than the flow rate of the refrigerant flowing per unit area of each of the first portions 121-1 and 121-2 related to the first regions 21-1 and 21-2. As a result, the cooling component 5 can efficiently cool the second region 22 having a higher temperature than each of the first regions 21-1 and 21-2 of the heating body 2. As described above, the cooling component 5 can efficiently cool the portion of the heating body 2 that generates heat at a higher temperature without increasing the area of the heat sink.

### [First modification of third example embodiment]

Fig. 8 to Fig. 11 illustrate the configuration example of the cooling component 5 in a case where an interval at which each of the protruding sections 51-1 to 51-n is provided, an interval at which each of the protruding sections 11-1 to 11-n is provided, and an interval at which each of the protruding sections 52-1 to 52-n is provided are the same. In the cooling component according to the first modification of the third example embodiment, the interval at which each of the protruding sections 51-1 to 51-n is provided, the interval at which each of the protruding sections 11-1 to 11-n is provided, and the interval at which each of the protruding sections 52-1 to 52-n is provided are different from each other. Since the interval at which each of the protruding sections 51-1 to 51-n is provided is different from the interval at which each of the protruding sections 52-1 to 52-n is provided, the first region 21-1 of the heating body 2 is cooled by the cooling component of the present modification with an efficiency different from that of the first region 21-2.

In the cooling component of the present modification, the interval at which each of the protruding sections 11-1 to 11-n is provided may be different from the interval at which each of the protruding sections 51-1 to 51-n is provided and the interval at which each of the protruding sections 52-1 to 52-n is provided. In this case, the interval at which each of the protruding sections 11-1 to 11-n is provided is an interval at which the flow rate of the refrigerant flowing per unit area of the second portion 122 related to the second region 22 is larger than the flow rate of the refrigerant flowing per unit area of each of the first portions 121-1 and 121-2 related to the first regions 21-1 and 21-2.

### [Second modification of third example embodiment]

Fig. 8 to 11 illustrate the configuration example of the cooling component 5 in a case where the thickness of each of the protruding sections 51-1 to 51-n and the thickness of each of the protruding sections 52-1 to 52-n are W2 and of the same thickness. In the cooling component of the second modification of the third example embodiment, the thickness of each of the protruding sections 51-1 to 51-n and the thickness of each of the protruding sections 52-1 to 52-n may be different from each other. Since the thickness of each of the protruding sections 51-1 to 51-n is different from the thickness of each of the protruding sections 52-1 to 52-n, the first region 21-1 of the heating body 2 is cooled by the cooling component of the present modification with an efficiency different from that of the first region 21-2.

### [Third modification of third example embodiment]

In a case where there are two or more second regions in the heating body, the cooling component of the third modification of the third example embodiment includes a protruding section in each of the second portions related to the second regions. The cooling component of the present modification may include a second portion in which the protruding section is not provided among the second portions related to the plurality of second regions.

### [Fourth modification of third example embodiment]

In the cooling component according to the fourth modification of the third example embodiment, in the heating body, at least one of the interval and the thickness of the protruding section provided in the second portion is not uniform. At least one of the interval and the thickness of the protruding section provided in the first portion of the cooling component of the fourth modification of the third example embodiment may not be uniform. For example, the designer of the cooling component may perform the simulation of cooling the heating body using the cooling component provided with the plurality of protruding sections having different intervals and different thicknesses. Then, the designer of the cooling component may mount, in an information processing apparatus, the cooling component that exhibits desirable performance in the simulation among the plurality of cooling components having different at least one of the interval or the thickness of the protruding section.

The designer of the cooling component can acquire temperature distribution of the heating body by any method. For example, the temperature distribution of the heating body can be acquired by the method described in the first modification of the first example embodiment. As described above, the cooling component is designed based on the temperature distribution of the heating body.

### [Fifth modification of third example embodiment]

In the cooling component according to the fifth modification of the third example embodiment, the heat receiving plate 12 is formed integrally with the protruding sections 51-1 to 51-n, the protruding sections 11-1 to 11-n, and the protruding sections 52-1 to 52-n. The heat receiving plate 12 of the cooling component of the present modification is a base of the heat sink, and the protruding sections 51-1 to 51-n, the protruding sections 11-1 to 11-n, and the protruding sections 52-1 to 52-n constitute the fins of the heat sink.

Each of the embodiments described above is a preferred embodiment of the present invention, and various modifications can be made without departing from the gist of the present invention.

While the invention has been particularly shown and described with reference to example embodiments thereof, the invention is not limited to these example embodiments. It will be understood by those of ordinary skill in the art that various changes in form and details may be made therein without departing from the spirit and scope of the present invention as defined by the claims.

This application is based upon and claims the benefit of priority from Japanese patent application No. 2021-082123, filed on May 14, 2021, the disclosure of which is incorporated herein in its entirety by reference.

### Reference Signs List

1, 3, 5 cooling components
11-1 to 11-n, 31-1 to 31-n, 32-1 to 32-n, 51-1 to 51-n, 52-1 to 52-n protruding sections
12 heat receiving plate
121-1, 121-2, 123-1, 123-2, 123-3 first portions
122, 124-1, 124-2 second portions
13 supply port
14 discharge port
15-1 to 15-n, 33-1 to 33-n, 34-1 to 34-n, 53, 54 flow passages
16-1, 16-2, 35-1, 35-2, 35-3 blocks
2, 4 heating bodies
21-1, 21-2, 41-1, 41-2, 41-3 first regions
22, 42-1, 42-2 second regions

## Claims

1. A cooling component comprising:
a first portion related to a first region of a heating body and a second portion related to a second region of the heating body, the second portion having a higher temperature than the first region, the second portion including a plurality of protruding sections, wherein
each of the plurality of protruding sections of the second portion forms a flow passage through which a refrigerant passes, and
the flow passage is not provided in the first portion.

2. A cooling component comprising
a first portion related to a first region of a heating body and a second portion related to a second region of the heating body, the second portion having a higher temperature than the first region, the second portion including a plurality of protruding sections, wherein
the first portion includes a plurality of protruding sections thicker than the plurality of protruding sections of the second portion, and
each of the plurality of protruding sections of the second portion and the plurality of protruding sections of the first portion forms a flow passage through which a refrigerant passes.

3. The cooling component according to claim 2, wherein
in a case where there is a plurality of the first regions, a plurality of protruding sections of the first portion is provided in each of the first portions related to each of the plurality of first regions.

4. The cooling component according to any one of claims 1 to 3, wherein
the refrigerant is water.

5. The cooling component according to any one of claims 1 to 4, wherein
in a case where there is a plurality of the second regions, a plurality of protruding sections of the second portion is provided in each of the second portions related to each of the plurality of second regions.

6. The cooling component according to any one of claims 1 to 5, further comprising:
a heat receiving plate that receives heat from the heat generator, wherein
the first portion includes a portion of the heat receiving plate facing the first region of the heating body, and the second portion includes another portion of the heat receiving plate facing the second region of the heating body.
